# EUROPEAN PATENT APPLICATION

(11) **EP 4 848 114 A1**
(43) Date of publication of application: **02.12.2026**
(21) Application number: 26181083.2
(22) Date of filing: 26.05.2026
(51) Int. Cl.: G06F 17/16, G06F 12/02, G11C 7/06

(54) **COMPUTATIONAL MEMORY DEVICE, COMPUTATIONAL MEMORY SYSTEM, AND COMPUTING SYSTEM**

(30) Priority: 28.05.2025 US 202563813550 P; 28.04.2026 US 202619660884
(71) Applicant: SK hynix Inc., Bubal-eub Icheon-si, Gyeonggi-do 17336 (KR)
(72) Inventor: CHOI, Jung Min, 17336 Icheon-si, Gyeonggi-do (KR); LEE, Ji Min, San Jose, 95134 (US)
(74) Representative: Isarpatent

(57) **Abstract**

A technique is provided for writing row data of a first matrix and column data of a second matrix to the same memory column in a column direction, performing a partial multiplication operation and an addition operation between the row data and the column data written to the same memory column, thereby performing a matrix calculation based on the row data of the first matrix and the column data of the second matrix using an operation of a memory, and improving operating performance of a system performing a computational function.

## Description

### BACKGROUND

Embodiments of the present disclosure relate to a computational memory device, a computational memory system, and a computing system.

A computing system may include a processor that performs various calculations or processes using data. The type of processor may vary, and the computing system may include various types of memory devices for storing data required when calculations are performed by the processor.

The memory device included in the computing system may be a volatile memory or a non-volatile memory. The processor may store and read data using the volatile memory or the non-volatile memory, perform calculations based on the data, and provide results.

The amount of data used for calculations performed by the processor is increasing, and the amount of data moved between the processor and the memory device is increasing, which may degrade the operating performance of the computing system.

### SUMMARY

Embodiments of the present disclosure may provide a technique capable of providing a computational function by a memory device and improving the operating performance of a computing system including the memory device and a processor.

Embodiments of the present disclosure may provide a computational memory system including: a memory including a plurality of sub-arrays, each of the plurality of sub-arrays including a plurality of memory cells; and a memory controller configured to write first row data of an i-th row (i is an integer ≥ 1) of a P X Q matrix (P, Q are integers ≥ 1) into a first memory cell group of a k-th column (k is an integer ≥ 1) of the plurality of memory cells in a column direction, write first column data of a j-th column (j is an integer ≥ 1) of an L X M matrix (L, M are integers ≥ 1) into a second memory cell group of the k-th column in the column direction, control an operation based on the first row data and the first column data by operating at least a portion of the first memory cell group or the second memory cell group, and control an operation in which first intermediate result data generated according to the operation is written into a third memory cell group of the k-th column in the column direction.

According to embodiments of the present disclosure, a computational function is provided using the basic structure of a memory device, and the operating performance of a computing system including the memory device and a processor can be improved.

The embodiments of the present disclosure are not limited to the features and advantages expressly described above. Other features and advantages will be apparent to those skilled in the art from the description and the claims.

### BRIEF DESCRIPTION OF THE DRAWINGS

The present disclosure will be more fully understood from the detailed description provided below and the accompanying drawings, which are provided for illustration only, and thus do not limit the content of the present disclosure.
FIG. 1 is a diagram illustrating an example of a schematic configuration of a computing system according to embodiments of the present disclosure.
FIG. 2 is a diagram illustrating an example of a structure of a computational memory system according to embodiments of the present disclosure.
FIG. 3 is a diagram illustrating an example of a manner in which a computational memory system performs a calculation according to embodiments of the present disclosure.
FIGS. 4A and 4B are diagrams illustrating an example of a manner in which a computational memory system writes data to a memory for calculation according to embodiments of the present disclosure.
FIGS. 5A and 5B are diagrams illustrating an example of a manner in which a computational memory system performs a calculation using data written according to the manner shown in FIGS. 4A and 4B according to embodiments of the present disclosure.
FIG. 6 is a diagram illustrating another example of a manner in which a computational memory system writes data to a memory for calculation according to embodiments of the present disclosure.
FIGS. 7A and 7B are diagrams illustrating an example of a manner in which a computational memory system performs a calculation using data written according to the manner shown in FIG. 6 according to embodiments of the present disclosure.
FIG. 8 is a diagram illustrating an example of an operating method of a computational memory system according to embodiments of the present disclosure.

### DETAILED DESCRIPTION OF THE EXEMPLARY EMBODIMENTS

Hereinafter, some embodiments of the present disclosure will be described in detail with reference to the exemplary drawings. In adding reference numerals to components of each drawing, the same components may have the same reference numerals as much as possible even though they are displayed on different drawings. In addition, in describing the present disclosure, if it is determined that a detailed description of a related known configuration or function may obscure the gist of the present disclosure, the detailed description thereof may be omitted. When "comprises," "has," "consists of," etc. mentioned in this specification are used, other parts may be added unless "only" is used. When a component is expressed in the singular, it may include the plural unless specifically stated otherwise.

In addition, in describing the components of the present disclosure, terms such as first, second, A, B, (a), (b), etc. may be used. These terms are only for distinguishing the component from other components, and the nature, order, sequence, or quantity of the components is not limited by these terms.

In the description of the positional relationship of components, when it is described that two or more components are "connected," "coupled," or "linked" to each other, it should be understood that the two or more components may be directly "connected," "coupled," or "linked," but other components may be further "interposed" between the two or more components to be "connected," "coupled," or "linked." Here, the other components may be included in one or more of the two or more components that are "connected," "coupled," or "linked" to each other.

In the description of the temporal flow relationship related to components, operation methods, or manufacturing methods, for example, when a temporal precedence relationship or a flow precedence relationship is described as "after," "subsequent to," "next to," "before," etc., cases that are not continuous may also be included unless "immediately" or "directly" is used.

Meanwhile, when a numerical value or its corresponding information (e.g., level, etc.) for a component is mentioned, even if there is no separate explicit description, the numerical value or its corresponding information may be interpreted as including an error range that may occur due to various factors (e.g., process factors, internal or external impact, noise, etc.).

Hereinafter, various embodiments of the present disclosure will be described in detail with reference to the accompanying drawings.

As used herein, the term "memory column" may refer to a set of memory cells electrically connected to the same bit line. Writing data "in a column direction" or "in the column direction" may refer to writing data to different memory cells connected to the same bit line. A "memory cell group" may refer to a designated subset of memory cells within a memory column that stores a particular category of data, such as operand data or result data. For example, a "first memory cell group," a "second memory cell group," and a "third memory cell group" within the same memory column may respectively store row data of a first matrix, column data of a second matrix, and intermediate result data generated according to an operation based on the row data and the column data.

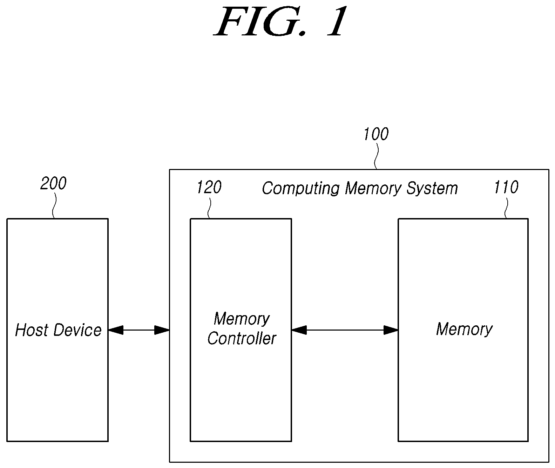

FIG. 1 is a diagram illustrating an example of a schematic configuration of a computing system according to embodiments of the present disclosure.

Referring to FIG. 1, a computing system according to embodiments of the present disclosure may include a computational memory system 100 and a host device 200.

The computational memory system 100 may include at least one memory 110. The computational memory system 100 may, in some cases, include a memory controller 120. The memory controller 120 may perform a function of controlling the operation of the memory 110.

In some cases, the computational memory system 100 may not include the memory controller 120. In this case, at least some of the functions of the memory controller 120 may be performed by the host device 200. Alternatively, a function of controlling the memory 110 may be performed by the memory controller 120 included in the computational memory system 100 and the host device 200. When the computational memory system 100 includes only the memory 110, it may be referred to as a computational memory device. Also, the memory 110 performing a computational function may be referred to as a computational memory device.

The memory 110 may include a plurality of memory cells that store data. The memory 110 may include a plurality of word lines and a plurality of bit lines for the operation of the memory cells. The word line may control the operation timing of the memory cell. The bit line may be used to write data to the memory cell or read data written to the memory cell. The memory cell may include at least one circuit element such as a transistor or a capacitor, and the configuration included in the memory cell may vary depending on the type of the computational memory system 100.

The memory controller 120 may control the operation of the memory 110. The memory controller 120 may control an operation of writing data to the memory 110 or reading data written to the memory 110. Depending on the type of the computational memory system 100, the memory controller 120 may control a refresh operation for the memory cells or control an operation of erasing data written to the memory cells.

The memory controller 120 may control the operation of the memory 110 according to a command received from the outside of the computational memory system 100. In some cases, the memory controller 120 may control the operation of the memory 110 based on its own command.

For example, the memory controller 120 may control the operation of the memory 110 according to a command transmitted by the host device 200. According to the command of the host device 200, the memory controller 120 may write data to the memory 110 or read data written to the memory 110 and provide it to the host device 200.

The host device 200 may be, for example, a computer, a UMPC (Ultra Mobile PC), a workstation, a PDA (Personal Digital Assistant), a tablet, a mobile phone, a smartphone, an e-book, a PMP (Portable Multimedia Player), a portable game console, a navigation device, a black box, a digital camera, a DMB (Digital Multimedia Broadcasting) player, a smart television, a digital voice recorder, a digital audio player, a digital video recorder, a digital video player, a digital video recorder, a digital video player, storage constituting a data center, one of various electronic devices constituting a home network, one of various electronic devices constituting a telematics network, an RFID (Radio Frequency Identification) device, a mobile device capable of driving under human control or autonomous driving (e.g., a vehicle, a robot, a drone), etc. Alternatively, the host device 200 may be a virtual/augmented reality device that provides a 2D or 3D virtual reality image or augmented reality image. In addition to the above examples, the host device 200 may be any one of various electronic devices requiring the computational memory system 100 capable of storing data for data processing.

The host device 200 may include at least one operating system. The operating system may generally manage and control the functions and operations of the host device 200, and may control the interaction between the host device 200 and the computational memory system 100. The operating system may be classified into a general operating system and a mobile operating system according to the mobility of the host device 200.

The host device 200 may include at least one processor. The host device 200 may, in some cases, include at least one local memory used by the processor. The local memory may be a volatile memory, but is not limited thereto.

The processor included in the host device 200 may be, for example, a processing device such as a Central Processing Unit (CPU), a Graphic Processing Unit (GPU), a Neural Processing Unit (NPU), a Tensor Processing Unit (TPU), a Data Processing Unit (DPU), etc., but is not limited thereto.

The memory controller 120 may be a device separate from the host device 200 or the processor included in the host device 200. In some cases, the memory controller 120 and the host device 200 or the processor included in the host device 200 may be integrated and implemented as a single device. All functions of the memory controller 120 may be integrated and implemented in the host device 200, or some functions of the memory controller 120 may be integrated and implemented in the host device 200. Hereinafter, for convenience of description, a case where the memory controller 120 is a device separate from the host device 200 and is disposed inside the computational memory system 100 will be described as an example, but embodiments of the present disclosure are not limited thereto.

The type of the memory 110 included in the computational memory system 100 may vary. The memory 110 of the computational memory system 100 may be, for example, a volatile memory such as DRAM, SDRAM, DDR SDRAM, LPDDR SDRAM, etc., but embodiments of the present disclosure are not limited thereto. The memory 110 may be a non-volatile memory such as a NAND flash memory, a 3D NAND flash memory, a NOR flash memory, etc. Also, in some cases, the computational memory system 100 may include a volatile memory and a non-volatile memory.

In addition, the memory 110 included in the computational memory system 100 may be one of various types of memories such as a resistive RAM, a phase-change memory, a magnetoresistive memory, a ferroelectric memory, or a spin-transfer torque magnetic memory.

In addition, the memory 110 included in the computational memory system 100 may, in some cases, be a Processing-In-Memory (PIM), Compute-In-Memory (CIM), or Compute-Using-Memory (CUM) that includes a computational function or a data processing function. The memory 110 providing a computational function may be one of the aforementioned volatile memory, non-volatile memory, and various next-generation memories, but is not limited thereto. The computational function may be provided by a logic circuit located inside the memory 110, or a computational function based on the operation of memory cells of the memory 110 may be provided.

In addition, the memory 110 included in the computational memory system 100 may be arranged in a structure in which a plurality of memories 110 are stacked. The stacked memories 110 may communicate with the memory controller 120 through wiring located outside the memory 110, or may communicate with the memory controller 120 through wiring located inside the memory 110. The wiring located inside the memory 110 may be implemented as, for example, a through-electrode, but is not limited thereto. In addition, the memory 110 may be a high bandwidth memory in which volatile memories or non-volatile memories are stacked, and in this case, a base die or a logic die may be disposed under a memory die (or core die). The memory controller 120 may be included and disposed in the base die or the logic die.

Describing an example where the memory 110 included in the computational memory system 100 is a volatile memory, a configuration performing a computational function may be located inside or outside a bank included in the memory 110. When the configuration performing the computational function is located outside the bank, it may be located adjacent to the bank or may be located in an area spaced apart from the bank.

In addition, the computational memory system 100 may, in some cases, provide a computational function using the memory 110. In order to perform a calculation using the memory 110, a separate configuration may be additionally disposed in the memory 110. Alternatively, a computational function using the structure of memory cells for data storage may be provided without an additional configuration being disposed in the memory 110.

When the computational memory system 100 provides a computational function, the computational memory system 100 may perform a part of the calculation by the host device 200 and provide the calculation result to the host device 200. The memory controller 120 may control whether to perform the computational function of the computational memory system 100, the timing of performing the computational function, and the like. As the computational function is provided by the computational memory system 100, the operating performance of a computing system performing data processing using the computational memory system 100 may be improved.

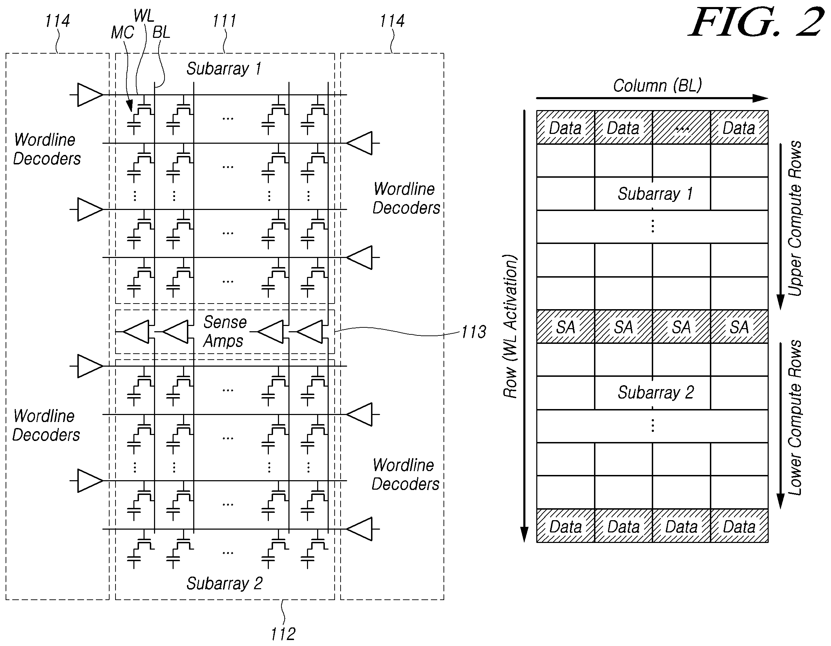

FIG. 2 is a diagram illustrating an example of a structure of a computational memory system 100 according to embodiments of the present disclosure.

Referring to FIG. 2, the memory 110 included in the computational memory system 100 may include a plurality of memory cells MC. The memory cell may include a transistor and a capacitor. The memory cell may be disposed in an area where a word line WL and a bit line BL intersect. The word line may be disposed along a first direction, for example. The bit line may be disposed along a second direction intersecting the first direction. The first direction may be, for example, a row direction or a direction in which word lines are disposed, and the second direction may be a column direction or a direction in which bit lines are disposed, but they are not limited thereto.

The memory 110 may include at least one sense amplifier 113 located between memory cells. The memory 110 may include a word line decoder 114 that outputs a signal for driving the word line.

The word line decoder 114 may be referred to as a word line driver, and the word line decoder 114 may drive word lines in units of rows or in units of predetermined areas. The word line decoder 114 may be electrically connected to, for example, two or more word lines, but is not limited thereto.

The sense amplifier 113 may be electrically connected to, for example, two or more bit lines. A calculation operation may be performed using the memory cells and at least one circuit disposed in the memory 110.

For example, the memory 110 may include a first sub-array 111 and a second sub-array 112. The first sub-array 111 may include a plurality of memory cells. The first sub-array 111 may include word lines and bit lines for driving the memory cells. The second sub-array 112 may include a plurality of memory cells. The second sub-array 112 may include word lines and bit lines for driving the memory cells.

The first sub-array 111 and the second sub-array 112 may share the sense amplifier 113. The sense amplifier 113 may be located between the first sub-array 111 and the second sub-array 112. The sense amplifier 113 may be electrically connected to at least one of the bit lines disposed in the first sub-array 111. The sense amplifier 113 may be electrically connected to at least one of the bit lines disposed in the second sub-array 112. The bit line of the first sub-array 111 and the bit line of the second sub-array 112 connected to the sense amplifier 113 may be located in the same column, but are not limited thereto.

The sense amplifier 113 may include at least one circuit element such as a transistor, and may be electrically connected to at least one voltage line other than the bit line.

The sense amplifier 113 may operate during a period in which an operation of writing data to the first sub-array 111 or the second sub-array 112 or an operation of reading data written to the first sub-array 111 or the second sub-array 112 is performed. The sense amplifier 113 may amplify the voltage of the bit line in a state where the bit line connected to the sense amplifier 113 is precharged, thereby allowing data write and read operations to be performed.

During the amplification operation by the sense amplifier 113, the voltage of one of the two bit lines connected to the sense amplifier 113 may increase and the voltage of the other may decrease. One voltage and the other voltage of the two bit lines may have levels inverted from each other. A calculation operation using the memory 110 may be controlled using the operation of writing and reading data to and from the sub-array and the operation of amplifying the voltage of the bit line by the sense amplifier 113. In an embodiment, when memory cells storing A, B, and Cin are simultaneously coupled to the same precharged bit line, charge sharing causes the bit line to resolve, through the sense amplifier 113, to a value corresponding to a majority of A, B, and Cin. This operation may be used to generate a carry output bit.

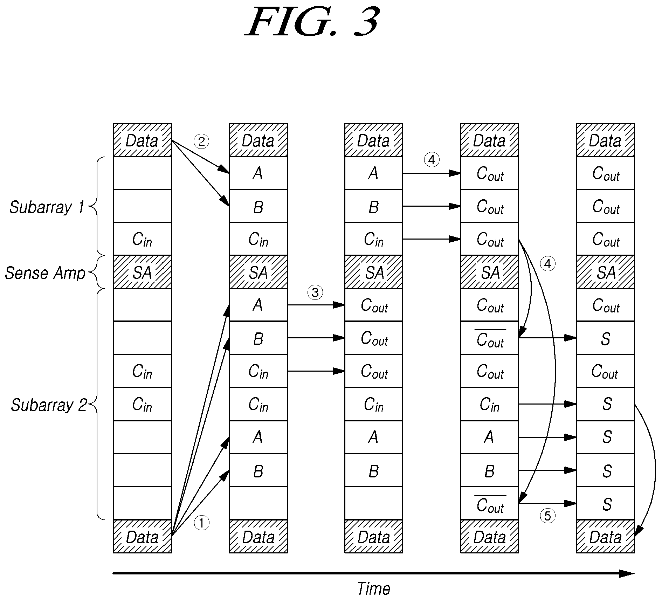

FIG. 3 is a diagram illustrating an example of a manner in which a computational memory system 100 performs a calculation according to embodiments of the present disclosure.

Referring to FIG. 3, an example is shown in which a calculation is performed using the first sub-array 111 and the second sub-array 112 sharing the sense amplifier 113. An example is shown in which data stored in memory cells disposed in the same column in the first sub-array 111 and the second sub-array 112 changes over time and a calculation is performed.

A carry-in bit Cin may be stored in a part of the first memory cells of the first sub-array 111 and a part of the memory cells of the second sub-array 112. The carry-in bit may be a part of operand data. Alternatively, the carry-in bit may mean a carry generated according to a calculation of a number of a lower bit (or lower digit) during an addition or multiplication operation using binary numbers.

In a state where the carry-in bit is stored, other operand data A and B may be written to the second sub-array 112 (①). A and B may be written to two rows in the second sub-array 112, respectively. In order for A and B to be written to the second sub-array 112, an operation of activating word lines of memory cells in the second sub-array 112 where A and B are to be written and precharging bit lines may be performed. If the memory cell where A and B are stored and the memory cell where A and B are copied cannot be turned on simultaneously, a certain time interval (e.g., 3 ns) may exist between activation periods. Depending on the implementation method of the decoder controlling the activation timing of each memory cell, if the memory cell where A and B are stored and the memory cell where A and B are copied can be turned on simultaneously, the certain time interval may not exist. Since operand data is copied from the stored memory cells to the second sub-array 112, four copy operations may be performed.

Also, A and B may be written to the first sub-array 111 (②). A and B may be written to one row in the first sub-array 111, respectively. In order for A and B to be written to the first sub-array 111, an operation of activating word lines of memory cells in the first sub-array 111 where A and B are to be written and precharging bit lines may be performed. Since operand data is copied from the stored memory cells to the first sub-array 111, two copy operations may be performed.

A majority function operation based on the operand data stored in the second sub-array 112 may be performed (③). For example, a majority function operation based on A and B stored in the upper three rows of the second sub-array 112 and a Cin value corresponding to the carry-in bit may be performed. The word lines of the memory cells of the second sub-array 112 where A, B, and Cin are stored may be activated. Charges of the memory cells of the second sub-array 112 where A, B, and Cin are stored are shared, and a carry-out bit Cout based on A, B, and Cin may be stored in a memory cell of the second sub-array 112 after the sense amplifier 113 amplifies the resulting bit line voltage. When the carry-in bit is set to 0, the result of the majority function operation based on A, B, and Cin may be the result of an AND operation based on A and B. The result of a multiplication operation of A and B may be provided by the majority function operation based on A, B, and Cin.

A majority function operation based on the operand data stored in the first sub-array 111 may be performed (④). The majority function operation and an inversion operation may be performed continuously. For example, a majority function operation based on A, B, and Cin stored in the upper three rows of the first sub-array 111 may be performed, and a carry-out bit generated according to the operation may be stored in a memory cell of the first sub-array 111.

Thereafter, the sense amplifier 113 between the first sub-array 111 and the second sub-array 112 may operate. A memory cell in which the carry-out bit is stored in the first sub-array 111 and a memory cell in which data is to be stored in the second sub-array 112 may be activated. Here, the memory cell of the first sub-array 111 may be referred to as a temporary memory cell, and the memory cell of the second sub-array 112 may be referred to as a result memory cell. As the temporary memory cell and the result memory cell are activated and the sense amplifier 113 operates, a carry-out bit obtained by inverting the carry-out bit stored in the temporary memory cell may be stored in the result memory cell. The inverted carry-out bit may be stored in at least two or more memory cells included in the second sub-array 112. As a value obtained by inverting data stored in the memory cell of the first sub-array 111 is stored in the memory cell of the second sub-array 112 according to the operation of the sense amplifier 113 connected between the first sub-array 111 and the second sub-array 112, a NOT operation may be performed.

A majority function operation based on at least some operand data stored in the memory cells of the second sub-array 112 may be performed (⑤). For example, a majority function operation based on the inverted carry-out bit, the carry-in bit, and A and B values may be performed. A sum bit may be generated according to the majority function operation. The sum bit may be stored in a memory cell of the second sub-array 112 where the operand data is stored. The sum bit may be output as a result value. The result of the majority function operation based on A, B, the carry-in bit, and two inverted carry-out bits may be the result of an XOR operation based on A and B. The above-described calculation method may be used for an XOR operation based on binary numbers, and may also be used for an addition operation of A and B.

A majority function operation may be performed in the first sub-array 111 and the second sub-array 112, and an inversion operation through the sense amplifier 113 may be performed between the first sub-array 111 and the second sub-array 112. A computational function may be provided in the computational memory system 100 without an additional configuration being disposed in the memory 110.

A calculation between data written to the same column in the sub-array may be performed. Even when a more complex calculation is performed, data is written in the column direction in the same column of the sub-array, and a calculation according to the operation of the memory 110 may be performed and a result may be provided. The column direction may mean a bit line direction. Writing data in the column direction may mean writing to different memory cells connected to the same bit line.

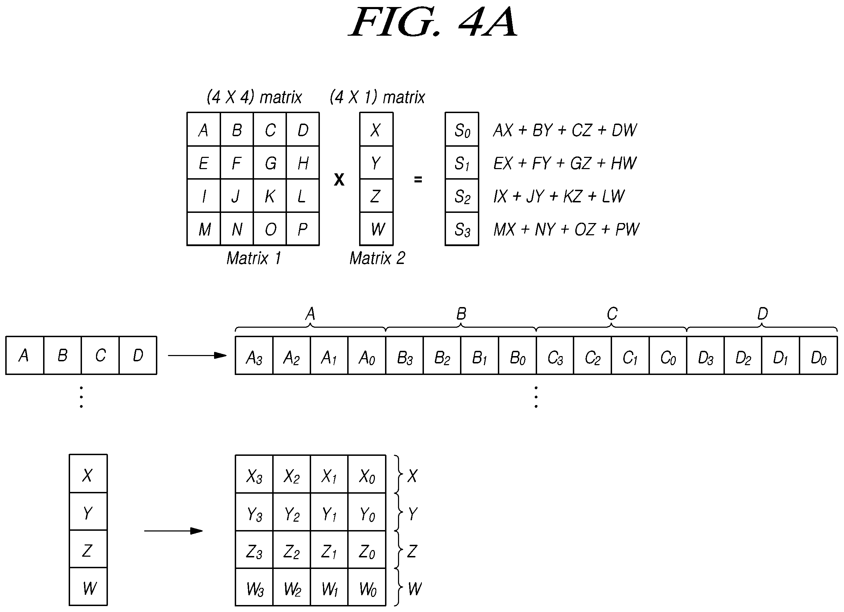

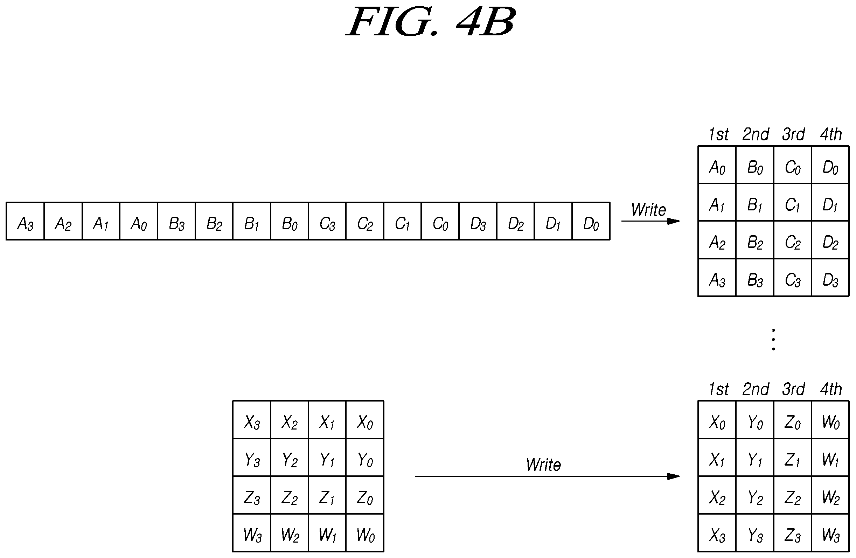

FIGS. 4A and 4B are diagrams illustrating an example of a manner in which a computational memory system 100 writes data to a memory 110 for calculation according to embodiments of the present disclosure.

Referring to FIG. 4A, the computational memory system 100 may perform a calculation according to a request of the host device 200. The manner in which the computational memory system 100 performs a calculation according to the request of the host device 200 may vary. The computational memory system 100 may receive a calculation command and data to be calculated from the host device 200. The computational memory system 100 may perform a calculation on the data to be calculated according to the calculation command. The data to be calculated may be a matrix, a vector, etc., but is not limited thereto.

In addition, the computational memory system 100 may store data in the memory 110 according to a request of the host device 200. The computational memory system 100 may perform a calculation on pre-stored data according to a calculation command received from the host device 200.

The computational memory system 100 may provide result data according to the performed calculation to the host device 200. Alternatively, the computational memory system 100 may store the result data in the memory 110 and provide the result data to the host device 200 upon receiving a request from the host device 200.

The calculation operation by the computational memory system 100 may be controlled by the memory controller 120. Alternatively, the calculation operation by the computational memory system 100 may be controlled by the host device 200. The memory 110 of the computational memory system 100 may operate under the control of the memory controller 120 or the host device 200 to perform a calculation. Hereinafter, a case where the memory 110 operates under the control of the memory controller 120 and a calculation is performed will be described as an example, but embodiments of the present disclosure are not limited thereto.

The memory controller 120 may write data to be calculated to the memory 110 according to a request of the host device 200. The memory controller 120 may write data according to rows and columns of sub-arrays included in the memory 110. When the data to be calculated is a matrix, the first matrix may be a P X Q matrix (P, Q are integers ≥ 1) and the second matrix may be an L X M matrix (L, M are integers ≥ 1). FIG. 4A exemplarily shows a case where the first matrix is a 4 X 4 matrix and the second matrix is a 4 X 1 matrix.

The memory controller 120 may, for example, write to a sub-array of the memory 110 according to rows and columns of data included in the matrix. For example, first row data of the first row of the first matrix may be A, B, C, D. Second row data of the second row of the first matrix may be E, F, G, H. Third row data of the third row of the first matrix may be I, J, K, L. Fourth row data of the fourth row of the first matrix may be M, N, O, P.

A first row value of the first row data of the first row of the first matrix may be A. A second row value of the first row data may be B, a third row value of the first row data may be C, and a fourth row value of the first row data may be D. Each row value included in the first row data may consist of, for example, 4 bits, but is not limited thereto.

A may be represented as A3, A2, A1, A0. A3 may be the most significant bit and A0 may be the least significant bit. A3, A2, A1, A0 may be, for example, 0 or 1. Data A may be represented in binary. A3, A2, A1, A0 representing A may be sequentially written to memory cells.

Similarly, B3, B2, B1, B0 corresponding to B, C3, C2, C1, C0 corresponding to C, and D3, D2, D1, D0 corresponding to D may be written to memory cells.

Row data of the remaining rows of the first matrix may be similarly written to memory cells.

First column data of the first column of the second matrix may be X, Y, Z, W. Each of X, Y, Z, W may also be 4 bits. X may be represented as X3, X2, X1, X0. Similarly, Y, Z, W may also be represented as 4-bit values. Column data of the second matrix may be written to memory cells according to rows and columns of the second matrix.

During the calculation of the first matrix and the second matrix, a partial multiplication operation and an addition operation may be performed between the first row data of the first matrix and the first column data of the second matrix. Similarly, a partial multiplication operation and an addition operation may be performed between the second row data of the first matrix and the first column data of the second matrix.

When a calculation between row data of the first matrix and column data of the second matrix is performed using memory cells, the row data and the column data may be written along the column direction of memory cells arranged in the sub-array for efficient calculation performance.

For example, referring to FIG. 4B, each of the first row data A, B, C, D of the first matrix may be written in the column direction in memory cells of the sub-array. A3, A2, A1, A0 corresponding to A may be written in the column direction in the first memory column. The least significant bit A0 may be written first, but in some cases, the most significant bit A3 may be written first.

B3, B2, B1, B0 corresponding to B may be written in the second memory column. C3, C2, C1, C0 corresponding to C may be written in the third memory column. D3, D2, D1, D0 corresponding to D may be written in the fourth memory column.

The first column data of the second matrix on which a calculation is performed with the first row data of the first matrix may also be written in the column direction in the sub-array.

For example, X3, X2, X1, X0 corresponding to X of the first column data of the second matrix may be written in the column direction in the first memory column. Y3, Y2, Y1, Y0 corresponding to Y may be written in the column direction in the second memory column. Z3, Z2, Z1, Z0 corresponding to Z may be written in the column direction in the third memory column. W3, W2, W1, WO corresponding to W may be written in the column direction in the fourth memory column. The least significant bit in each column value of the first column data may be written first, but in some cases, the most significant bit may be written first.

Row data and column data on which a calculation is performed with each other may be written in the same column. For example, A and X may be written in the first memory column. B and Y may be written in the second memory column, and C and Z may be written in the third memory column. D and W may be written in the fourth memory column.

Since values on which a calculation is performed with each other are written in the same column, the memory controller 120 may operate memory cells disposed in the same column to control a calculation operation based on data written to the memory cells.

Alternatively, data to be calculated may be copied to other memory cells in the same column. For example, a memory cell in which data is stored and a memory cell to which data is copied may operate simultaneously, and charges of two memory cells disposed in the same column may be shared. Data of the memory cell in which data is stored may be copied to another memory cell, and the other memory cell may be referred to as a computational memory cell. Row data and column data on which a calculation is performed with each other may be copied to a computational memory cell located in the same column, and a calculation operation based on the two data may be performed according to the operation of the computational memory cell group.

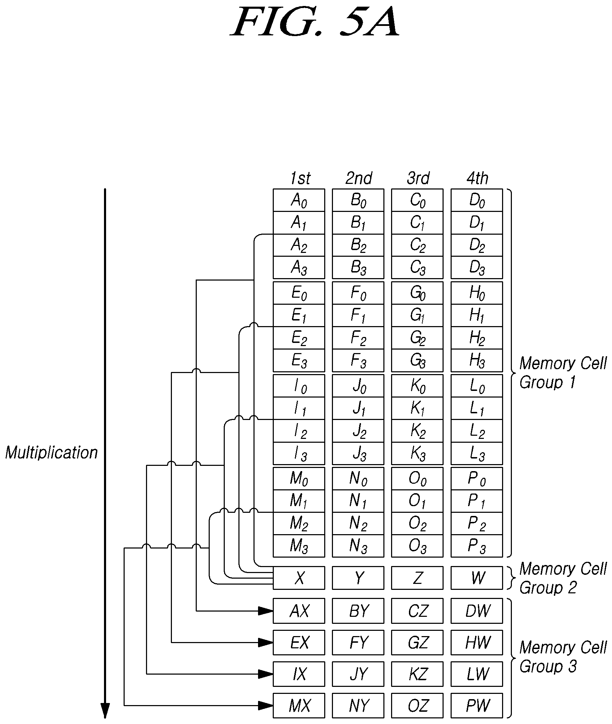

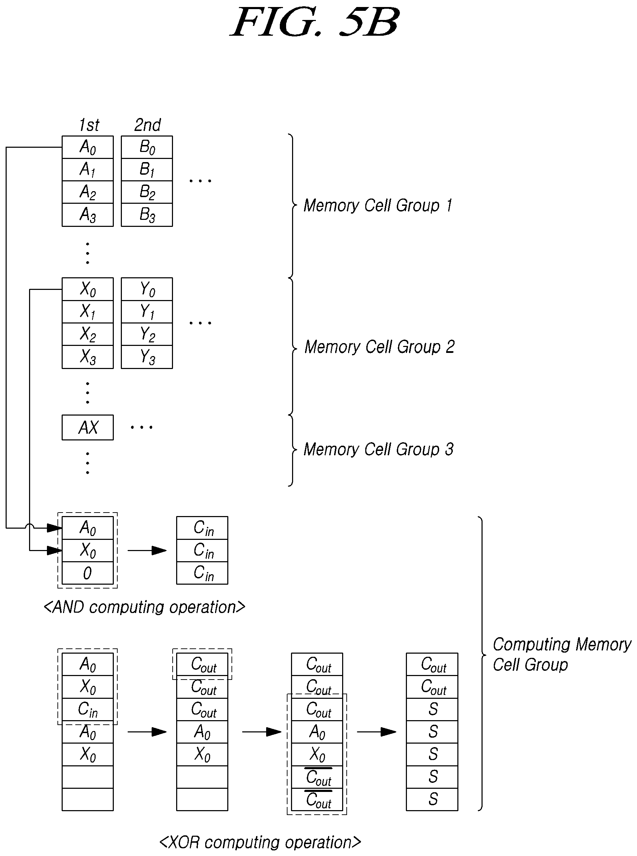

FIGS. 5A and 5B are diagrams illustrating an example of a manner in which a computational memory system 100 performs a calculation using data written according to the manner shown in FIGS. 4A and 4B according to embodiments of the present disclosure.

Referring to FIG. 5A, when performing the calculation between the first matrix and the second matrix shown in FIG. 4A, the memory controller 120 may write data of the first matrix to a first memory cell group. The memory controller 120 may write data of the second matrix to a second memory cell group.

The first row data A, B, C, D of the first row of the first matrix may be written to the same memory row. Each of A, B, C, D may be written in the column direction.

The second row data E, F, G, H of the second row of the first matrix may be written to the same memory row. Each of E, F, G, H may be written in the column direction. Each of E, F, G, H may be written to the same memory column as each of A, B, C, D.

The third row data of the third row and the fourth row data of the fourth row of the first matrix may also be written to the first memory cell group in the same manner.

The first column data X, Y, Z, W of the first column of the second matrix may be written to the same memory row. Although not shown in FIG. 5A, each of X, Y, Z, W may be written in the column direction.

X of the second matrix may be calculated with A, E, I, M of the first matrix. X may be written to the same memory column as A, E, I, M. Similarly, data of the first matrix and data of the second matrix on which a calculation is performed with each other may be written to the same memory column.

The memory controller 120 may control a calculation operation of the first matrix and the second matrix by operating the first memory cell group and the second memory cell group.

In a state where data is written to the first memory cell group and the second memory cell group, the memory controller 120 may operate the first memory cell group and the second memory cell group to control a calculation operation of the data of the first matrix and the data of the second matrix. For example, the memory controller 120 may operate the first memory column to control a calculation operation between A and X. The memory controller 120 may operate the first memory column to control a calculation operation between E and X. The memory controller 120 may control a calculation operation between data written to the first memory column in a similar manner.

The memory controller 120 may control a calculation operation by operating another memory column during at least a portion of a period in which the first memory column is operated to control the calculation operation. For example, the memory controller 120 may operate the second memory column during a period in which the first memory column is operated, thereby controlling at least a part of a calculation operation between B, F, J, N and Y. Since row data of the same row of the first matrix is written to the same memory row, a calculation operation based on a plurality of data included in the matrix may be simultaneously performed through simultaneous driving of the memory row and the memory column.

The memory controller 120 may write intermediate result data generated according to the calculation operation between the data of the first matrix and the data of the second matrix to a third memory cell group. The intermediate result data may be written to the same column as the memory column where the data of the first matrix and the data of the second matrix are written.

For example, first intermediate result data AX, EX, IX, MX generated according to the calculation operation between A, E, I, M and X may be written to the first memory column of the third memory cell group. The first intermediate result data may be written to the same memory column as A, E, I, M, X. The first intermediate result data AX, EX, IX, MX may be values generated according to a partial multiplication operation between the row data of the first matrix and the column data of the second matrix.

Similarly, second intermediate result data BY, FY, JY, NY generated according to the calculation operation between B, F, J, N of the first matrix written to the second memory column and Y of the second matrix may be written to the second memory column of the third memory cell group. Calculation results for data written to the third memory column and the fourth memory column may similarly be written to the third memory column and the fourth memory column of the third memory cell group.

The intermediate result data written to the third memory cell group is a value according to a partial multiplication operation between the data of the first matrix and the data of the second matrix, and may be generated through an AND operation and an XOR operation according to the operation of memory cells.

For example, referring to FIG. 5B, a calculation operation between A written to the first memory column of the first memory cell group and X written to the first memory column of the second memory cell group is exemplarily shown.

A3, A2, A1, A0 may be written to the first memory column of the first memory cell group. X3, X2, X1, X0 may be written to the second memory column of the second memory cell group. For the calculation of A and X, the first memory cell group and the second memory cell group may operate, or A and X may be copied to a computational memory cell group and the computational memory cell group may operate.

For example, when A and X are copied to the computational memory cell group, A0 and X0 may be copied to the computational memory cell group and an AND operation may be performed. For example, three memory cells to which A0, X0, and 0 are written may operate simultaneously and a majority function operation may be performed. A result value Cin according to the majority function operation of A0, X0, 0 may be written to three memory cells. Cin may be a result value according to an AND operation of A0, X0. The AND operation may be used for a multiplication operation between two bits. Also, the AND operation may be used to calculate a carry during an addition operation between two bits. The result value according to the AND operation may be stored in a temporary memory cell and then moved to a designated memory cell after all calculation operations are completed.

When performing an XOR operation based on A0 and X0, A0, X0, Cin, A0, X0 may be written to five memory cells. Three memory cells to which A0, X0, Cin are written may operate simultaneously and a majority function operation may be performed. Cout according to the majority function operation of A0, X0, Cin may be written to three memory cells. Cout may be moved from a sub-array connected by the sense amplifier 113, a NOT operation may be performed, and inverted Cout may be written to a memory cell. After a calculation operation for calculating Cout is performed in the sub-array connected by the sense amplifier 113, Cout may be moved according to the operation of the sense amplifier 113 and inverted Cout may be written to a memory cell. A majority function operation based on A0, X0, inverted Cout and an additional copy of inverted Cout may be performed. A sum bit S of the majority function operation may be stored. S may be a value according to an XOR operation based on A0 and X0. The XOR operation may be used during an addition operation of two bits. Also, the XOR operation may be used in various ways in a process of performing a partial multiplication operation and an addition operation between data of a matrix.

Intermediate result data AX according to the calculation operation performed according to the operation of memory cells in the computational memory cell group may be written to the third memory cell group. The memory controller 120 may operate the same memory column and write intermediate result data according to a partial multiplication operation between data of the matrix written to the memory column to the third memory cell group.

Final result data according to the calculation of the first matrix and the second matrix may be provided by an addition operation between intermediate result data. Referring to FIG. 5A, a result of an addition operation based on AX, BY, CZ, DW written to the first memory row of the third memory cell group may be provided as final result data according to a calculation between the first row data of the first row of the first matrix and the first column data of the first column of the second matrix. For example, as a value according to a calculation between first row data of an i-th row of a P X Q matrix and first column data of a j-th column of an L X M matrix, a value corresponding to an i-th row and a j-th column of a P X M matrix generated according to the calculation of the P X Q matrix and the L X M matrix may be provided.

The memory controller 120 may provide AX, BY, CZ, DW written to the third memory cell group to the host device 200 according to a request of the host device 200. The host device 200 may perform an addition operation based on the read AX, BY, CZ, DW to calculate final result data. Alternatively, the memory controller 120 may perform an addition operation based on the read AX, BY, CZ, DW, and provide final result data according to the addition operation to the host device 200. In this case, the memory controller 120 may include a logic circuit providing a computational function.

Alternatively, the memory controller 120 may change a manner of writing data of a matrix to the first memory cell group and the second memory cell group, control an addition operation based on the operation of memory cells, and thereby provide final result data obtained by adding intermediate result data through the memory 110.

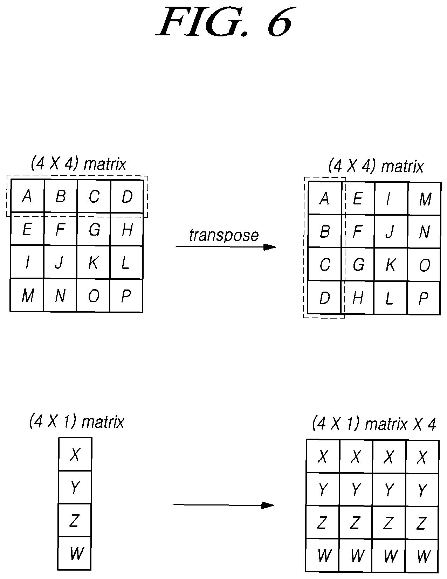

FIG. 6 is a diagram illustrating another example of a manner in which a computational memory system 100 writes data to a memory 110 for calculation according to embodiments of the present disclosure.

Referring to FIG. 6, the computational memory system 100 may perform a calculation between a first matrix and a second matrix according to a request of the host device 200. The computational memory system 100 may write data of the first matrix and data of the second matrix to the memory 110, operate the memory 110, and provide result data according to the calculation of the first matrix and the second matrix to the host device 200.

For example, the memory controller 120 may receive a calculation command requesting a calculation of the first matrix and the second matrix from the host device 200. The first matrix may be a 4 X 4 matrix and the second matrix may be a 4 X 1 matrix.

When performing the calculation of the first matrix and the second matrix, the memory controller 120 may transform (or transpose) the first matrix and write it to the memory 110. In an embodiment, transposing the first matrix converts each row of the first matrix into a column, so that data elements from the same row are written to the same memory column. Each row data of the first matrix may be written in the column direction.

For example, the memory controller 120 may transpose the first matrix and write each row of the first matrix in the column data direction to memory cells of the memory 110. First row data A, B, C, D of the first row of the first matrix may be sequentially written to the first memory column. Second row data E, F, G, H of the second row of the first matrix may be sequentially written to the second memory column. Row data of the remaining rows of the first matrix may be written to memory columns in a similar manner.

The memory controller 120 may repeatedly write column data of the second matrix to memory columns where row data of the first matrix is written. For example, the memory controller 120 may write the first column data X, Y, Z, W of the second matrix to each memory column where row data of the first matrix is written in the column direction. X, Y, Z, W may be written to the first memory column where A, B, C, D are written. X, Y, Z, W may be written to the second memory column where E, F, G, H are written. X, Y, Z, W may be written to the third memory column and the fourth memory column.

The first matrix may be transposed so that each row data of the first matrix is written in the column direction in the same memory column. Column data of the second matrix calculated with row data of the first matrix may be written to the same memory column as the row data of the first matrix.

A partial multiplication operation may be performed between data written to the same memory column. Also, final result data according to a calculation between data of the matrix may be provided by an addition operation between data written to the same memory column.

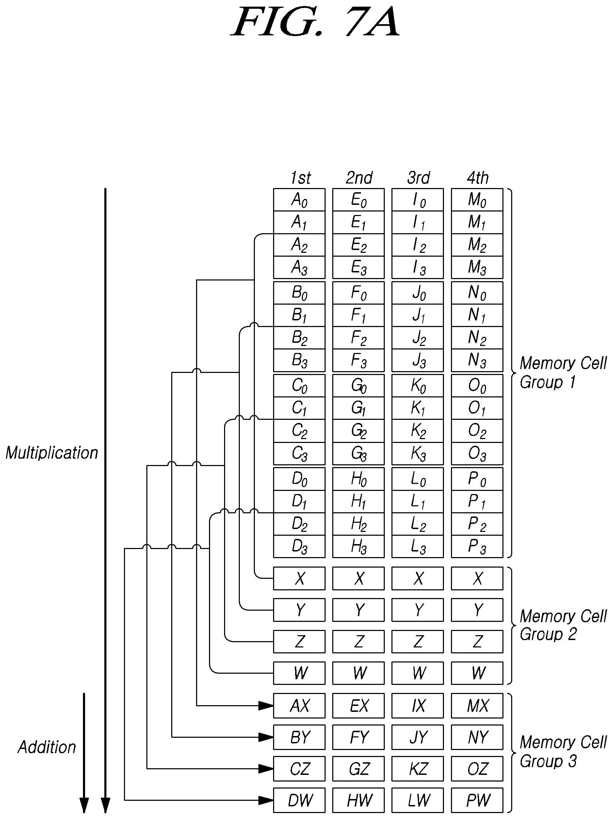

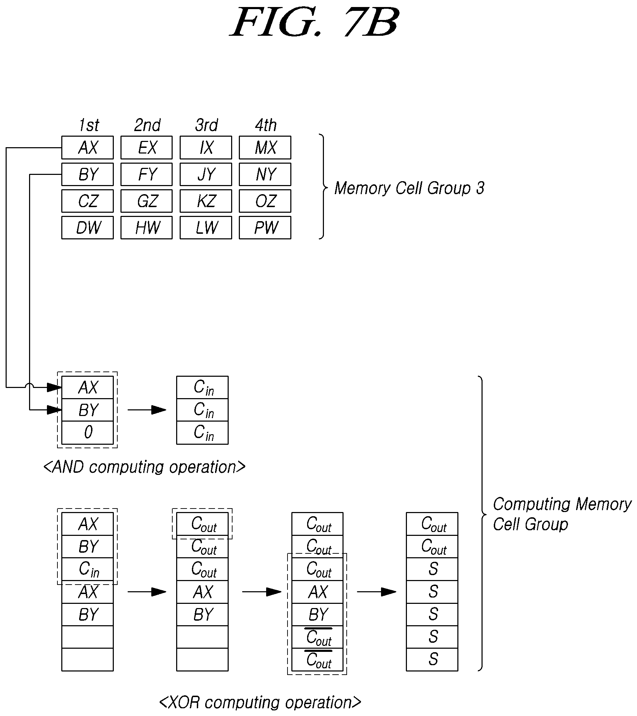

FIGS. 7A and 7B are diagrams illustrating an example of a manner in which a computational memory system 100 performs a calculation using data written according to the manner shown in FIG. 6 according to embodiments of the present disclosure.

Referring to FIG. 7A, an example is shown in which data of the first matrix and data of the second matrix are written to memory cells. Data of the first matrix may be written to a first memory cell group. The first matrix may be transposed so that each row data of the first matrix is written in the column direction for each memory column.

For example, first row data A, B, C, D of the first row of the first matrix may be written in the column direction in the first memory column of the first memory cell group. Second row data E, F, G, H of the second row of the first matrix may be written in the column direction in the second memory column of the first memory cell group. The remaining row data of the first matrix may be written to the third memory column and the fourth memory column. In some cases, each row data may be written to non-adjacent memory columns. Even in this case, row data calculated with the same column data may be written to the same memory row.

First column data of the first column of the second matrix may be written in the column direction in the first memory column of the second memory cell group. The first column data of the second matrix may be written to the second memory column, the third memory column, and the fourth memory column of the second memory cell group. The first column data of the second matrix may be written to the same memory column as each of the row data of the first matrix. The operation of memory cells for calculation between data written to the same memory column may be controlled.

For example, the memory controller 120 may operate the first memory cell group and the second memory cell group to control an operation for a partial multiplication operation between data written to the first memory cell group and data written to the second memory cell group. Alternatively, the memory controller 120 may copy data written to the first memory cell group and the second memory cell group to a computational memory cell group and operate the computational memory cell group to control a calculation operation.

For example, the memory controller 120 may copy row data written to a memory column of the first memory cell group and column data written to a memory column of the second memory cell group to a memory column of the computational memory cell group. Data of the first matrix and data of the second matrix written to the same memory column may be copied to the same memory column. The memory controller 120 may operate the computational memory cell group to control an operation for a partial multiplication operation between the data of the first matrix and the data of the second matrix.

The memory controller 120 may write intermediate result data according to a partial multiplication operation between data of the first matrix and data of the second matrix written to the same memory column to a third memory cell group. Intermediate result data according to a partial multiplication operation between data written to the same memory column may be written to the same memory column of the third memory cell group.

For example, intermediate result data according to a partial multiplication operation between A, B, C, D written to the first memory column of the first memory cell group and X, Y, Z, W written to the first memory column of the second memory cell group may be written to the first memory column of the third memory cell group. AX, BY, CZ, DW may be written to the same memory column.

Similarly, EX, FY, GZ, HW may be written to the second memory column of the third memory cell group. IX, JY, KZ, LW may be written to the third memory column of the third memory cell group. MX, NY, OZ, PW may be written to the fourth memory column of the third memory cell group.

The memory controller 120 may control an operation for an addition operation based on intermediate result data written to the same memory column of the third memory cell group. Since the memory controller 120 can control an operation for an addition operation between data written to the same memory column, final result data according to an addition operation based on intermediate result data written to the same memory column may be written to memory cells. Intermediate result data written in the column direction in the third memory cell group may be added in the column direction, and final result data may be provided. The calculation of adding intermediate result data to calculate final result data may be performed, for example, through operations for an AND operation and an XOR operation.

For example, referring to FIG. 7B, intermediate result data may be written to the first memory column, the second memory column, the third memory column, and the fourth memory column of the third memory cell group. The memory controller 120 may control an operation for an addition operation for each memory column of the third memory cell group.

For example, the memory controller 120 may copy AX and BY written to the first memory column of the third memory cell group to the computational memory cell group. In some cases, the memory controller 120 may control an operation for an addition operation by operating the third memory cell group without copying the intermediate result data written to the third memory cell group to the computational memory cell group.

The memory controller 120 may write AX, BY, and 0 to the same memory column. The memory controller 120 may control an operation for a majority function operation based on AX, BY, 0. According to the operation for the majority function operation, memory cells to which AX, BY, 0 are written operate simultaneously, charges are shared between memory cells, and a result value Cin may be written to three memory cells. A result value according to an AND operation between AX and BY may be provided.

The memory controller 120 may write AX, BY, Cin to a memory column, and additionally write AX, BY to the memory column. A majority function operation between AX, BY, Cin may be performed and a result value Cout may be provided. The memory controller 120 may operate the sense amplifier 113 electrically connected to the memory column where Cout is written, and write an inverted Cout value to the memory column through data movement between sub-arrays connected through the sense amplifier 113. A majority function operation based on AX, BY, Cout and two inverted Cout may be performed. A result value S according to the majority function operation may be provided. A result value according to an XOR operation between AX and BY may be provided.

The memory controller 120 may control at least a part of an AND operation and an XOR operation based on intermediate result data written to the same memory column in the third memory cell group through the operation of memory cells. Final result data according to an addition operation between AX, BY, CZ, DW written in the column direction may be provided. The memory controller 120 may write the final result data to each memory column.

For example, the memory controller 120 may write final result data according to an addition operation between AX, BY, CZ, DW written to the first memory column of the third memory cell group to memory cells of the first memory column. The memory controller 120 may write final result data according to an addition operation between EX, FY, GZ, HW written to the second memory column of the third memory cell group to memory cells of the second memory column. Similarly, the memory controller 120 may write final result data according to an addition operation based on intermediate result data written to the third memory column and the fourth memory column of the third memory cell group to memory cells of each memory column.

The memory controller 120 may provide the final result data to the host device 200 according to a request of the host device 200 or upon completion of the calculation operation. The host device 200 may receive an AX+BY+CZ+DW value generated according to the calculation operation performed in the first memory column. Similarly, the host device 200 may receive EX+FY+GZ+HW, IX+JY+KZ+LW, and MX+NY+OZ+PW values.

The memory controller 120 may read the corresponding data and provide it to the host device 200. The host device 200 may receive a result value according to the calculation of the first matrix and the second matrix. The calculation of the first matrix and the second matrix may be performed by the computational memory system 100 and only the result value may be provided to the host device 200. The amount of data transmitted and received between the host device 200 and the computational memory system 100 may be reduced, and as the calculation is performed by the computational memory system 100, the operating performance of the host device 200 or a computing system including the host device 200 and the computational memory system 100 may be improved.

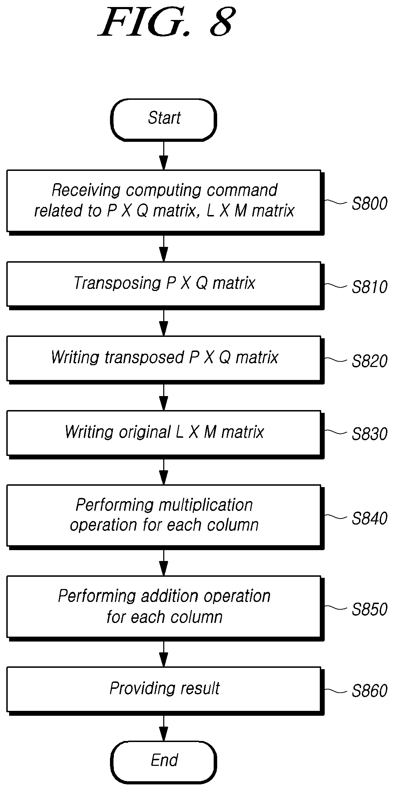

FIG. 8 is a diagram illustrating an example of an operating method of a computational memory system 100 according to embodiments of the present disclosure.

Referring to FIG. 8, the computational memory system 100 may receive a calculation command from the host device 200 (S800). The calculation command may be, for example, a command instructing a calculation between a P X Q matrix and an L X M matrix. The calculation command may be a command instructing a calculation based on a matrix, a vector, etc., but is not limited thereto, and may be a command instructing various calculations performed using data stored in the memory 110.

The computational memory system 100 may receive a calculation command and data of a matrix to be calculated according to the calculation command from the host device 200. Alternatively, after receiving a command to write data of a matrix from the host device 200, the computational memory system 100 may receive a calculation command instructing a calculation based on the data of the matrix written to the memory 110.

The computational memory system 100 may transpose the P X Q matrix to control a calculation operation between the P X Q matrix and the L X M matrix (S810). For example, the computational memory system 100 may transpose the P X Q matrix to generate a Q X P matrix. The computational memory system 100 may write data of the Q X P matrix as the transposed P X Q matrix to the memory 110 (S820). Alternatively, the computational memory system 100 may write data of the P X Q matrix to the memory 110 in a form in which the P X Q matrix is transposed. Each row data of the P X Q matrix may be written in the column direction to a memory column of the memory 110.

The computational memory system 100 may write the L X M matrix to the memory 110 (S830). The computational memory system 100 may write column data of the L X M matrix to a memory column of the memory 110 in the column direction. The column data of the L X M matrix may be written to a memory column where row data of the P X Q matrix is written. The column data of the L X M matrix may be written for each memory column where a plurality of row data of the P X Q matrix are written. The same column data may be written to a plurality of memory columns. Row data of the P X Q matrix and column data of the L X M matrix may be written to the same memory column. A calculation between data written to the same memory column may be performed.

The computational memory system 100 may control an operation for a partial multiplication operation between data written to the same memory column (S840).

A memory column where row data of the P X Q matrix and column data of the L X M matrix are written operates, and an operation for at least one of an AND operation or an XOR operation may be performed. An operation for a partial multiplication operation between row data of the P X Q matrix and column data of the L X M matrix written to the same memory column may be performed. Intermediate result data generated according to the operation for the partial multiplication operation may be written to the memory column in the column direction. Intermediate result data may be written to a memory column where row data and column data to be calculated are written.

The computational memory system 100 may control an operation for an addition operation of adding intermediate result data written for each memory column in the column direction (S850).

The computational memory system 100 may operate a memory cell where intermediate result data is written or a memory cell to which intermediate result data is moved and copied to perform an operation for at least one of an AND operation or an XOR operation. Intermediate result data written to the same memory column is added in the column direction, and final result data may be generated. The computational memory system 100 may write the final result data to a memory cell. The final result data may be data included in a P X M matrix according to multiplication between row data of the P X Q matrix and column data of the L X M matrix. For example, data corresponding to an i-th row and a j-th column of the P X M matrix may be provided as final result data according to a calculation between row data of an i-th row of the P X Q matrix and column data of a j-th column of the L X M matrix.

The computational memory system 100 may provide the final result data to the host device 200 (S860). When the matrix calculation is completed, the computational memory system 100 may provide the final result data to the host device 200 in response to the calculation command. Alternatively, the computational memory system 100 may store the final result data in a predesignated memory cell and provide the final result data according to a request of the host device 200.

The computational memory system 100 may write data of a matrix to be calculated to the memory 110, and operate memory cells to which the data is written to control a calculation operation between data of the matrix. Final result data according to the calculation operation may be stored in the memory 110. Only data to be calculated and final result data may be transmitted and received between the host device 200 and the computational memory system 100. Various calculations may be performed while reducing the use of bandwidth between the host device 200 and the computational memory system 100.

Since a computational function is provided by the computational memory system 100, the computational performance of the host device 200 or a computing system including the host device 200 may be improved, and the operating performance of the entire system may be improved.

Embodiments of the present disclosure provide a computational memory device including: a first memory column electrically coupled to a plurality of word lines and a first bit line, the first memory column being configured such that first row data of a row of a first matrix is written into the first memory column in a column direction, first column data of a column of a second matrix is written into the first memory column in the column direction, and first intermediate result data according to a first operation based on the first row data and the first column data is written into the first memory column in the column direction; and a second memory column electrically coupled to the plurality of word lines and a second bit line, the second memory column being configured such that second row data of a next row of the first matrix is written into the second memory column in the column direction, the first column data of the column of the second matrix is written into the second memory column in the column direction, and second intermediate result data according to a second operation based on the second row data and the first column data is written into the second memory column in the column direction.

A memory cell to which the first row data is written and a memory cell to which the first column data is written in the first memory column operate simultaneously during at least a portion of a period, and a memory cell to which the second row data is written and a memory cell to which the first column data is written in the second memory column operate simultaneously during at least a portion of a period.

The first row data and the first column data are copied to a first computational memory cell included in the first memory column and the first operation based on the first row data and the first column data is performed according to an operation of the first computational memory cell.

The second row data and the first column data are copied to a second computational memory cell included in the second memory column and the second operation based on the second row data and the first column data is performed according to an operation of the second computational memory cell.

The first intermediate result data is written according to a partial multiplication operation and an addition operation based on the first row data and the first column data, and the second intermediate result data is written according to the partial multiplication operation and the addition operation based on the second row data and the first column data.

The first intermediate result data is added in the column direction and first final result data is provided, and the second intermediate result data is added in the column direction and second final result data is provided.

The first final result data is a value corresponding to the row and the column of a result matrix generated according to a calculation of the first matrix and the second matrix, and the second final result data is a value corresponding to the next row and the column of the result matrix.

The above description is merely illustrative of the technical spirit of the present disclosure, and various modifications and variations will be possible without departing from the essential characteristics of the present disclosure by those skilled in the art to which the present disclosure pertains. Therefore, the embodiments disclosed in the present disclosure are not intended to limit the technical spirit of the present disclosure but to explain it, and the scope of the technical spirit of the present disclosure is not limited by these embodiments.

## Claims

1. A computational memory system comprising:
a memory including a plurality of sub-arrays, each of the plurality of sub-arrays including a plurality of memory cells; and
a memory controller configured to:
write first row data of an i-th row (i is an integer ≥ 1) of a P X Q matrix (P, Q are integers ≥ 1) into a first memory cell group of a k-th column (k is an integer ≥ 1) of the plurality of memory cells in a column direction,
write first column data of a j-th column (j is an integer ≥ 1) of an L X M matrix (L, M are integers ≥ 1) into a second memory cell group of the k-th column in the column direction,
control an operation based on the first row data and the first column data by operating at least a portion of the first memory cell group or the second memory cell group, and
control an operation in which first intermediate result data generated according to the operation is written into a third memory cell group of the k-th column in the column direction.

2. The computational memory system of claim 1, wherein the first intermediate result data is a value obtained by multiplying each of a plurality of first row values included in the first row data and each of a plurality of first column values included in the first column data.

3. The computational memory system of claim 2, wherein the memory controller controls an operation in which the third memory cell group to which the first intermediate result data is written is operated and first final result data obtained by adding the first intermediate result data in the column direction is generated.

4. The computational memory system of claim 3, wherein the first final result data is a value corresponding to an i-th row and a j-th column of a P X M matrix generated according to a calculation of the P X Q matrix and the L X M matrix.

5. The computational memory system of claim 1, wherein the memory controller writes second row data of an (i+1)-th row of the P X Q matrix into a fourth memory cell group of a (k+n)-th column (n is an integer ≥ 1) of the plurality of memory cells in the column direction, and writes the first column data of the j-th column of the L X M matrix into a fifth memory cell group of the (k+n)-th column in the column direction.

6. The computational memory system of claim 5, wherein the memory controller operates the (k+n)-th column during at least a portion of a period in which the k-th column of the plurality of memory cells operates, controls an operation based on the second row data and the first column data written to the (k+n)-th column, and writes second intermediate result data generated according to the operation into a sixth memory cell group of the (k+n)-th column in the column direction.

7. The computational memory system of claim 6, wherein the memory controller operates the (k+n)-th column simultaneously with the k-th column and controls an operation in which second final result data based on the second intermediate result data is generated.

8. The computational memory system of claim 7, wherein the second final result data is a value obtained by adding the second intermediate result data written to the sixth memory cell group of the (k+n)-th column in the column direction.

9. The computational memory system of claim 1, wherein the memory controller operates the first memory cell group and the second memory cell group simultaneously and controls the operation based on the first row data and the first column data.

10. The computational memory system of claim 1, wherein the memory controller copies at least a portion of the first row data or the first column data to a computational memory cell group of the k-th column, operates the computational memory cell group, and controls the operation based on the first row data and the first column data.

11. The computational memory system of claim 10, wherein the first memory cell group and the second memory cell group are located in a first sub-array, at least a portion of the computational memory cell group is located in a second sub-array, and a sense amplifier electrically coupled between the first sub-array and the second sub-array is disposed.

12. The computational memory system of claim 11, wherein data is moved between the first sub-array and the second sub-array and a NOT operation is performed during at least a portion of a period in which the sense amplifier operates.

13. The computational memory system of claim 1, wherein the memory controller is configured to transpose the P X Q matrix to generate a Q X P matrix, and write the first row data into the first memory cell group in the column direction based on the Q X P matrix.

14. The computational memory system of claim 1, wherein the memory controller is configured to simultaneously couple a plurality of memory cells to a same precharged bit line to perform a majority function operation based on charge sharing among the plurality of memory cells, and generate the first intermediate result data based on a result of the majority function operation.

15. A computing system comprising:
a processor configured to output a calculation command based on a P X Q matrix (P, Q are integers ≥ 1) and an L X M matrix (L, M are integers ≥ 1); and
a computational memory system according to any one of claims 1 to 14.
